# FASCICULE DE BREVET EUROPEEN

(11) **EP 3 608 977 B1**
(45) Date de publication et mention de la délivrance du brevet: **17.02.2021**
(21) Numéro de dépôt: 19189875.8
(22) Date de dépôt: 02.08.2019
(51) Int. Cl.: H01L 31/173, H01L 25/16, H03K 17/78

(54) **OPTOCOUPLEUR**
OPTOKOPPLER
OPTOCOUPLER

(30) Priorité: 06.08.2018 FR 1857328
(43) Date de publication de la demande: 12.02.2020
(73) Titulaire: COMMISSARIAT À L'ÉNERGIE ATOMIQUE ET AUX ÉNERGIES ALTERNATIVES, 75015 Paris (FR)
(72) Inventeur: BUCKLEY, Julien, 38054 GRENOBLE Cedex 09 (FR); ESCOFFIER, René, 38054 GRENOBLE Cedex 9 (FR)
(74) Mandataire: Hautier, Nicolas

(56) Documents cités:
- WO-A1-2013/159693
- CN-A- 102 005 978
- US-A- 5 574 744
- US-A1- 2009 121 236

## Description

### DOMAINE TECHNIQUE DE L'INVENTION

L'invention concerne les dispositifs d'isolation électrique et plus particulièrement les coupleurs optiques également désignés optocoupleurs. Elle trouve au moins une application particulièrement avantageuse dans le domaine des convertisseurs de puissance.

### ÉTAT DE LA TECHNIQUE

Un convertisseur de puissance permet de convertir un signal électrique, par exemple un courant continu DC (acronyme de « Direct Current »), en un autre signal électrique, par exemple un courant alternatif AC (acronyme de « Alternate Current »).

Un tel convertisseur comprend généralement un circuit de contrôle ou contrôleur et un circuit de commande.

Le circuit de commande reçoit généralement en entrée un signal d'entrée issu du contrôleur. Le circuit de commande est en outre généralement alimenté électriquement en entrée par une alimentation.

Dans le cas d'un convertisseur DC/AC dit onduleur, le circuit de commande peut générer en sortie un signal de commande à destination d'un bras d'onduleur pour commander par exemple une commutation des interrupteurs de ce bras d'onduleur.

Pour convertir des signaux électriques présentant des tensions de quelques centaines de volts, une isolation en entrée et/ou en sortie du circuit de commande est très fréquente.

Cette isolation permet d'une part de protéger le circuit de commande, et d'autre part de s'affranchir des perturbations de la référence du signal de commande engendrées lors des commutations.

Le circuit de commande est généralement isolé de l'alimentation en entrée par une isolation galvanique. Cette isolation galvanique présente plusieurs inconvénients.

En effet, elle est encombrante et difficilement intégrable.

Par ailleurs, cette isolation galvanique limite l'intensité du courant des signaux d'entrée et/ou de sortie à quelques milliampères. Une telle isolation galvanique limite en outre la fréquence des signaux d'entrée et/ou de sortie à une centaine de kilohertz. L'inductance générée par cette isolation galvanique peut également induire des distorsions des signaux d'entrée et/ou de sortie.

Cette isolation galvanique ne permet pas d'obtenir une immunité totale du convertisseur de puissance face à un champ magnétique, typiquement pour un champ magnétique de 10 Gauss à 1 MHz.

Le circuit de commande peut être isolé du contrôleur par un dispositif de couplage optique dit optocoupleur.

Le document US 4996577 divulgue un optocoupleur comprenant une source de lumière couplée avec des cellules photovoltaïques empilées les unes sur les autres et dont les tranches sont disposées en regard de la source de lumière. L'optocoupleur permet de transmettre un signal électrique de faible puissance, typiquement un signal électrique d'une dizaine de volts et de quelques microampères.

Un tel optocoupleur ne peut cependant pas isoler électriquement le circuit de commande de l'alimentation.

Le document WO 2013/159693 A1 décrit un optocoupleur comprenant une source lumineuse et un récepteur en regard de la source lumineuse, la source lumineuse étant une matrice de diodes laser et étant configurée pour recevoir en entrée un signal électrique d'entrée, et générer en sortie en fonction dudit signal électrique d'entrée un signal lumineux à destination du récepteur, le récepteur étant une matrice de cellules photovoltaïques et étant configuré pour recevoir en entrée au moins en partie le signal lumineux et pour délivrer en sortie au moins un signal électrique de sortie au niveau de deux connexions de sortie, la matrice de cellules photovoltaïques et la matrice de diodes laser s'étendant principalement dans des plans parallèles et étant disposées en regard l'une de l'autre.

Chacun des documents US 5 574 744 A et CN 102 005 978 A décrit également un optocoupleur constitué d'une source lumineuse et d'un récepteur, la source lumineuse étant une matrice de diodes laser et le récepteur étant une matrice de cellules photovoltaïques.

Un objet de la présente invention est de pallier au moins en partie certains des inconvénients mentionnés ci-dessus.

Selon un aspect particulier, un objet de la présente invention est de proposer un optocoupleur permettant de transmettre des signaux électriques présentant une puissance compatible avec une alimentation d'un circuit de commande de convertisseur.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un premier aspect de l'invention concerne un optocoupleur, comprenant au moins une source lumineuse, faisant office d'émetteur, et au moins un récepteur en regard de l'au moins une source lumineuse. L'au moins une source lumineuse est configurée pour recevoir en entrée un signal électrique d'entrée, et générer en sortie en fonction dudit signal électrique d'entrée un signal lumineux à destination de l'au moins un récepteur. L'au moins un récepteur est configuré pour recevoir en entrée au moins en partie ledit signal lumineux et pour délivrer en sortie au moins un signal électrique de sortie au niveau de trois connexions de sortie agencées de manière à former une connexion à point milieu.

Selon l'invention, au moins une source lumineuse est une matrice de diodes laser et l'au moins un récepteur est une matrice de cellules photovoltaïques.

Selon l'invention, a matrice de cellules photovoltaïques et la matrice de diodes laser s'étendent principalement dans des plans parallèles.

Une telle configuration de sortie à point milieu permet avantageusement de délivrer le signal électrique de sortie avec une tension électrique positive ou avec une tension électrique négative, relativement au point milieu. Ce point milieu correspond typiquement à une référence de tension interne au dispositif. Cette référence de tension est donc indépendante de la référence de tension du signal électrique d'entrée.

L'optocoupleur peut ainsi délivrer un signal électrique de sortie présentant une tension de même signe ou de signe opposé à celle du signal électrique d'entrée. La versatilité de l'optocoupleur est ainsi améliorée. Cela augmente le nombre d'options de commande d'un système comprenant une source de puissance amont et un dispositif aval séparés par un tel optocoupleur.

La source de puissance amont est celle qui délivre le signal électrique d'entrée, par exemple une alimentation d'un circuit de commande de convertisseur.

Le dispositif aval est celui qui reçoit le signal électrique de sortie, par exemple un circuit de commande de convertisseur.

Selon l'invention et de façon particulièrement avantageuse, l'utilisation de diodes laser permet de délivrer le signal lumineux avec une puissance suffisante pour transmettre les signaux électriques d'alimentation à l'au moins une matrice de cellules photovoltaïques.

Un tel optocoupleur permet par exemple de transmettre des signaux électriques présentant une puissance de deux ordres de grandeur supérieure à celle transmise par le dispositif du document US 4996577.

L'utilisation de diodes laser permet également de transmettre les signaux électriques d'entrée de plus faible puissance issus du contrôleur à l'au moins une matrice de cellules photovoltaïques.

*In fine,* un tel optocoupleur peut donc être utilisé pour alimenter électriquement un circuit de commande d'un convertisseur, ou pour transmettre au circuit de commande un signal d'entrée issu d'un contrôleur.

L'utilisation d'un tel optocoupleur permet avantageusement de supprimer l'inductance parasite liée à une isolation galvanique.

L'isolation électrique d'un circuit de commande peut donc avantageusement se faire uniquement par l'utilisation de tels optocoupleurs.

Dès lors, la suppression de l'isolation galvanique et le remplacement de celle-ci par un tel optocoupleur permet un fonctionnement à haute fréquence, au moins jusqu'à 10 mégahertz, du circuit de commande.

Cela permet également de garantir une immunité élevée, voire totale, de la liaison entre le circuit de commande et le bras d'onduleur face à un champ magnétique.

Un tel optocoupleur présente également un encombrement limité et peut donc être facilement intégré dans le même boîtier que le circuit de commande.

Un autre aspect de l'invention concerne un système d'optocoupleur comprenant un boîtier, un support, au moins une puce assemblée sur ledit support, et au moins un optocoupleur selon le premier aspect de l'invention reporté sur ladite puce, l'au moins un optocoupleur, l'au moins une puce et le support étant situés dans le boîtier.

Selon une possibilité, le système comprend en outre dans le même boîtier un circuit électronique de commande d'un convertisseur de puissance connecté en entrée à un premier optocoupleur, et en sortie à un deuxième optocoupleur.

Le circuit électronique de commande peut être avantageusement reporté sur une puce commune aux premier et deuxième optocoupleurs.

L'encombrement d'un tel système est avantageusement limité.

L'invention proposée peut être avantageusement employée pour toute application nécessitant un convertisseur de puissance. A titre d'exemples non limitatifs, les véhicules électriques peuvent être équipés d'au moins un des aspects de l'invention ; les alimentations à découpage (régulation de la tension de sortie, convertisseurs AC/AC, AC/DC, DC/DC, DC/AC) peuvent comprendre l'un au moins des aspects de l'invention ; la transmission de données numériques isolées ou le pilotage de charges sur secteur à partir d'un circuit accessible basse tension peuvent également comprendre l'un au moins des aspects de l'invention.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
- La FIGURE 1 montre en coupe transverse un système d'optocoupleur selon un mode de réalisation de la présente invention ;
- La FIGURE 2A montre une vue de dessus du système d'optocoupleur illustré en FIGURE 1 ;
- La FIGURE 2B montre une vue de dessous du système d'optocoupleur illustré en FIGURE 1 ;
- La FIGURE 2C montre une vue de dessus d'un système d'optocoupleur selon un deuxième mode de réalisation de la présente invention ;
- Les FIGURES 3A et 3B illustrent respectivement une vue de dessus et une vue du dessous d'un système d'optocoupleur selon un troisième mode de réalisation de la présente invention ;
- La FIGURE 4 montre un schéma d'un convertisseur de puissance comprenant au moins un optocoupleur selon un mode de réalisation de la présente invention ;
- La FIGURE 5 montre en coupe transverse un système d'optocoupleur selon un autre mode de réalisation de la présente invention.
- La FIGURE 6 montre en coupe transverse un système d'optocoupleur selon un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

En particulier, les épaisseurs et dimensions des différentes couches et portions des dispositifs illustrés ne sont pas représentatives de la réalité.

### DESCRIPTION DÉTAILLÉE DE L'INVENTION

Avant d'entamer une revue détaillée de modes de réalisation de l'invention, il est rappelé que l'invention selon son premier aspect comprend notamment les caractéristiques optionnelles ci-après pouvant être utilisées en association ou alternativement :
- Selon un mode de réalisation, l'optocoupleur comprend une pluralité de connexions de sortie configurées pour délivrer une pluralité de signaux électriques de sortie. Ces signaux électriques peuvent être semblables entre eux. Alternativement, ils peuvent être différents entre eux.
- Selon un mode de réalisation, la matrice de diodes laser émet une lumière monochromatique présentant une longueur d'onde comprise entre 600 nm et 1100 nm.
- Selon un mode de réalisation, une partie au moins des cellules photovoltaïques de l'au moins une matrice de cellules photovoltaïques sont des cellules photovoltaïques à base de silicium.
- Selon un mode de réalisation, la matrice de diodes laser émet une lumière monochromatique présentant une longueur d'onde comprise entre 500 nm et 600 nm.
- Selon un mode de réalisation, une partie au moins des cellules photovoltaïques de l'au moins une matrice de cellules photovoltaïques sont des cellules photovoltaïques à base de gallium.
- Selon un mode de réalisation, l'au moins une matrice de cellules photovoltaïques comprend un nombre de cellules photovoltaïques compris entre 4 et 100.
- Selon un mode de réalisation, la matrice de diodes laser comprend un nombre de diodes laser inférieur ou égal au nombre de cellules photovoltaïques de l'au moins une matrice de cellules photovoltaïques.
- Selon un mode de réalisation, la matrice de cellules photovoltaïques et la matrice de diodes laser sont disposées en regard.
- Selon un mode de réalisation, le nombre de diodes laser est égal au nombre de cellules photovoltaïques et chaque cellule photovoltaïque de la matrice de cellules photovoltaïques est disposée en regard d'une diode laser correspondante de la matrice de diodes laser, comme indiqué ci-dessus. Ainsi, chaque diode laser est associée à une unique cellule photovoltaïque, et inversement. Des paires associant chacune une diode laser à une cellule photovoltaïque face à face sont ainsi formées.
- Selon un mode de réalisation, la matrice de diodes laser comprend des diodes laser à cavité verticale émettant par la surface VCSEL (acronyme de « vertical-cavity surface-emitting laser »).
- Selon un mode de réalisation, l'optocoupleur comprend une pluralité de matrices de cellules photovoltaïques, ladite pluralité de matrices de cellules photovoltaïques étant configurée pour délivrer en sortie une pluralité de signaux électriques de sortie.
- Selon un mode de réalisation, la matrice de diodes laser est configurée pour délivrer le signal lumineux à destination de la pluralité de matrices de cellules photovoltaïques.
- Selon un mode de réalisation, la source laser est séparée de l'au moins une matrice de cellules photovoltaïques par une couche en un matériau transparent à une longueur d'onde d'émission des diodes laser de la matrice de diodes laser.
- Selon un mode de réalisation, l'au moins un signal électrique de sortie est délivré au niveau de trois connexions de sortie agencées de manière à former une connexion à point milieu.
- Selon un mode de réalisation, l'optocoupleur comprend un boîtier à l'intérieur duquel est intégré l'au moins une source lumineuse et l'au moins une matrice de cellules photovoltaïques.
- Selon un mode de réalisation, le boîtier est configuré pour être rapporté sur une carte électronique.

L'invention selon son deuxième aspect comprend notamment les caractéristiques optionnelles ci-après pouvant être utilisées en association ou alternativement :
- Selon un mode de réalisation, le support est une grille de connexion.
- Selon un mode de réalisation, le système comprend en outre un circuit électronique de commande d'un bras d'onduleur, ledit circuit électronique étant connecté à au moins un optocoupleur.
- Selon un mode de réalisation, le système comprend en outre un circuit électronique de commande d'un bras d'onduleur, ledit circuit électronique présentant une entrée connectée à au moins un premier optocoupleur, et une sortie connectée à au moins un deuxième optocoupleur, dans lequel lesdits au moins premier et deuxième optocoupleurs, le circuit électronique et le support sont situés dans le boîtier.
- Selon un mode de réalisation, lesdits au moins premier et deuxième optocoupleurs et le circuit électronique sont reportés sur une même puce.
- Selon un mode de réalisation, le circuit électronique est un circuit de commande d'un bras d'onduleur.
- Selon un mode de réalisation, le circuit de commande présente une entrée d'alimentation connectée à une sortie de l'optocoupleur, ledit optocoupleur étant connecté en entrée à une alimentation électrique.
- Selon un mode de réalisation, le circuit de commande présente une entrée de contrôle connectée à une sortie de l'optocoupleur, ledit optocoupleur étant connecté en entrée à un contrôleur.
- Selon un mode de réalisation, le circuit de commande présente une première sortie connectée à une entrée d'un premier optocoupleur, ledit premier optocoupleur étant connecté en sortie à un premier transistor d'un bras d'onduleur, et dans lequel le circuit de commande présente une deuxième sortie connectée à une entrée d'un deuxième optocoupleur, ledit deuxième optocoupleur étant connecté en sortie à un deuxième transistor dudit bras d'onduleur.

Il est précisé que, dans le cadre de la présente invention, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Par ailleurs, la disposition relative d'une première couche sur une deuxième couche, ou d'une troisième couche intercalée entre une première couche et une deuxième couche, ne signifie pas obligatoirement que les couches sont directement au contact les unes des autres, mais signifie que ces couches sont soit directement au contact les unes des autres, soit séparées entre elles par au moins une autre couche ou au moins un autre élément.

On entend par un substrat, un dispositif, une couche, « à base » d'un matériau A, un substrat, un dispositif, une couche comprenant ce matériau A uniquement ou ce matériau A et éventuellement d'autres matériaux, par exemple des éléments d'alliage, des impuretés ou des éléments dopants, le matériau A présentant des propriétés avantageuses pour le substrat, le dispositif, ou la couche. Ainsi, une cellule photovoltaïque à base de gallium Ga peut comprendre une partie active en InGaP, ou en GaAs ou en InGaAs par exemple.

Dans la présente demande de brevet, un dopage noté P englobe tous les dopages par porteurs de charges positives quelle que soit la teneur du dopage. Ainsi, un dopage P comprend les teneurs en dopage P+ et les teneurs en dopage P inférieures au dopage de type P+. De même, un dopage noté N englobe tous les dopages par porteurs de charges négatives quelle que soit la teneur du dopage. Ainsi, un dopage N comprend les teneurs en dopage N+ et les teneurs en dopage N inférieures au dopage de type N+.

On entend par « matrice » un tableau sous forme de lignes et de colonnes. Par exemple, une matrice peut comprendre une pluralité de lignes et une pluralité de colonnes, ou une seule ligne et une pluralité de colonnes, ou encore une pluralité de lignes et une seule colonne. De préférence, dans le cadre de la présente invention, une matrice comprend plusieurs lignes et plusieurs colonnes.

Dans la présente demande de brevet, un laser ou une diode laser produit un rayonnement lumineux spatialement et temporellement cohérent. Un tel rayonnement lumineux présente une grande pureté spectrale et peut avantageusement transmettre différents signaux lumineux. Typiquement, la largeur spectrale du rayonnement laser est inférieure ou égale à 2 nm.

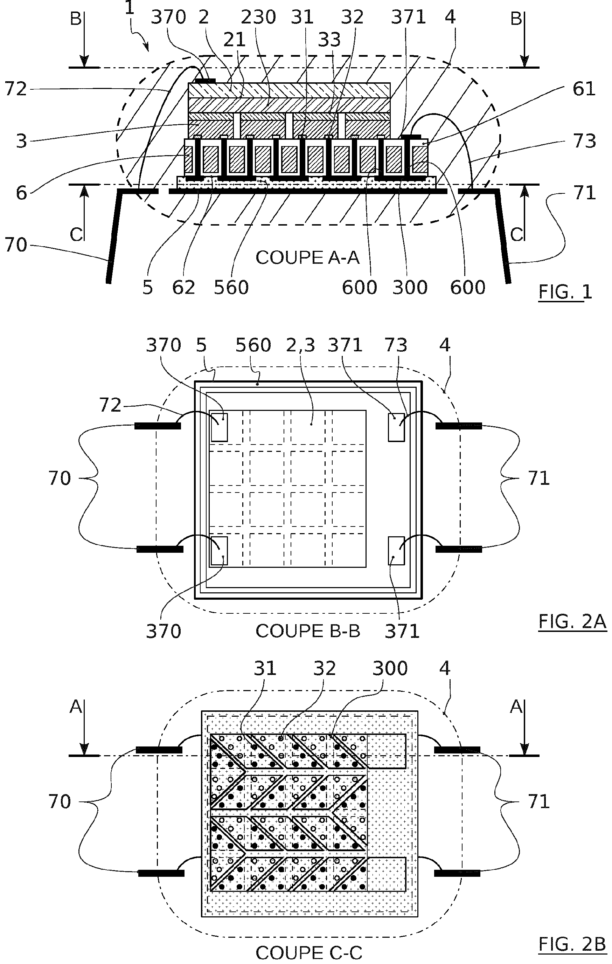

Selon l'invention, un premier mode de réalisation de l'optocoupleur va maintenant être décrit en référence aux figures 1, 2A, 2B.

L'optocoupleur 1 se présente de préférence sous la forme d'un empilement de composants 2, 3 réalisés ou assemblés sur une puce 6. Ces composants comprennent notamment une matrice de diodes laser 2 et une matrice de cellules photovoltaïques 3 tournée au regard de la matrice de laser 2. L'optocoupleur 1 comprend de préférence des connexions d'entrée 370 sur la matrice de diodes laser 2.

La matrice de diodes laser 2 peut être disposée sur une couche transparente 230 elle-même disposée sur la matrice de cellules photovoltaïques 3. Ainsi, la couche transparente 230 est interposée entre la matrice de diodes laser 2 et la matrice de cellules photovoltaïques 3, de préférence directement au contact desdites matrices 2, 3. La couche transparente 230 impose donc une distance entre ces deux matrices 2, 3.

Selon une possibilité, l'optocoupleur 1 comprend possiblement d'autres couches intermédiaires, transparentes, entre les matrices 2, 3.

Des connexions 31, 32 et des interconnexions 300 entre les cellules photovoltaïques de la matrice 3 peuvent être réalisées sur et/ou au travers de la puce 6, de manière à former des connexions de sortie 371 de l'optocoupleur 1.

Selon le mode de réalisation illustré en figure 1, l'empilement comprend ainsi successivement les éléments suivants : la puce 6, la matrice de cellules photovoltaïques 3, la couche transparente 230, la matrice de diodes laser 2.

Cet empilement est de préférence vertical.

Selon une possibilité préférée, cet empilement est logé dans un boîtier 4.

La matrice de diodes laser 2 et la matrice de cellules photovoltaïques 3 forment au moins en partie un système de conversion comprenant un premier étage de conversion configuré pour effectuer une première conversion d'un signal électrique d'entrée en un signal lumineux, et un deuxième étage de conversion configuré pour effectuer une deuxième conversion du signal lumineux en un signal électrique de sortie.

Ainsi, la matrice de diodes laser 2 peut être considérée comme un émetteur et la matrice de cellules photovoltaïques 3 peut être considérée comme un récepteur pour cet émetteur.

La première conversion se fait au niveau de la matrice de diodes laser 2.

Un signal électrique d'entrée peut être transmis par l'intermédiaire de deux connexions d'entrée 370 aux diodes laser de la matrice 2 reliées entre elles. Ces diodes peuvent être reliées en série ou en parallèle, de préférence en parallèle afin que la tension du signal d'entrée soit suffisamment faible.

Les diodes laser sont configurées pour émettre à partir du signal électrique d'entrée le signal lumineux de préférence à une longueur d'onde d'émission déterminée.

Les diodes laser de la matrice 2 peuvent être au nombre de quatre, par exemple arrangées selon un carré 2X2, ou plus, par exemple au nombre de seize selon un carré 4X4, par exemple au nombre de quatre-vingt-une selon un carré 9X9, voire plus.

Selon une autre possibilité, les diodes laser de la matrice 2 peuvent rester fixées au substrat sur lequel elles ont été fabriquées.

Les diodes laser de la matrice 2 peuvent être formées à base d'In ou à base de Ga, par exemple à base d'InGaP pour une longueur d'onde d'émission de l'ordre de 635nm, à base d'AIGaAs pour une longueur d'onde d'émission de l'ordre de 800nm, ou à base d'InGaAs pour une longueur d'onde d'émission de l'ordre de 1000nm.

Les diodes laser de la matrice 2 peuvent être de type VCSEL (acronyme anglais signifiant « vertical-cavity surface-emitting laser »), c'est-à-dire à cavité verticale émettant par la surface.

Ces diodes laser peuvent être monolithiques.

Une telle configuration VCSEL bien connue de l'homme du métier permet avantageusement de simplifier la fabrication de la matrice 2.

L'émission des diodes laser peut se faire à partir d'une surface tournée en regard de la matrice de cellules photovoltaïques 3.

Cette surface peut être une face inférieure 21 du premier étage de conversion après formation et/ou report de la matrice 2 sur la matrice 3.

Cette première conversion peut avantageusement permettre d'obtenir un signal lumineux de forte puissance.

Dès lors, un signal électrique d'entrée destiné à alimenter électriquement un circuit de commande peut être avantageusement converti en signal lumineux de forte puissance.

Cette première conversion peut présenter un rendement de conversion de l'ordre de 60% à 70%, par exemple environ égal à 66%.

La deuxième conversion se fait au niveau de la matrice de cellules photovoltaïques 3.

Les cellules photovoltaïques sont configurées pour recevoir le signal lumineux.

Selon un mode de réalisation, la matrice de diodes laser 2 s'étend selon un premier plan. La matrice de cellules photovoltaïques s'étend selon un deuxième plan. Les premiers et deuxièmes plans sont parallèles et disposés à distance l'un de l'autre.

Selon un mode de réalisation alternatif, la matrice de diodes laser 2 et la matrice de cellules photovoltaïques 3 s'étendent selon des surfaces courbes en regard l'une de l'autre.

Selon un mode de réalisation non limitatif, la matrice de diodes laser 2 et/ou la matrice de cellules photovoltaïques 3 comprend plusieurs lignes et plusieurs colonnes.

Les cellules photovoltaïques de la matrice 3 peuvent être au nombre de quatre, par exemple arrangées selon un carré 2X2, ou plus, par exemple au nombre de seize selon un carré 4X4, par exemple au nombre de quatre-vingt-une selon un carré 9X9, voire plus.

Selon un mode de réalisation, une cellule photovoltaïque, de préférence une seule cellule photovoltaïque, se trouve en regard de chaque diode laser. Selon un mode de réalisation possiblement combinable avec le précédent, une diode laser, de préférence une diode laser, se trouve en regard de chaque cellule photovoltaïque. Selon une possibilité, une cellule photovoltaïque de la matrice 3 correspond à une diode laser de la matrice 2.

Les cellules photovoltaïques de la matrice 3 peuvent être formées à base de silicium ou à base de Ga, par exemple à base d'InGaP, à base de GaAs, ou à base d'InGaAs en fonction de la longueur d'onde d'émission des diodes laser de la matrice 2.

Les cellules photovoltaïques de la matrice 3 peuvent être réalisées selon le procédé décrit dans le document US 9,647,161. On notera que dans ce document, les cellules photovoltaïques servent à alimenter le circuit intégré électronique. Dans ce document, les cellules photovoltaïques n'ont aucunement comme fonction de former une partie d'un optocoupleur. A fortiori, ce document n'envisage aucunement que les cellules photovoltaïques forment une partie d'une isolation d'un circuit de commande d'un convertisseur.

Conformément au procédé décrit dans ce document US 9,647,161, les cellules photovoltaïques peuvent être réalisées à partir d'un empilement de type SOI (acronyme de l'anglais « silicon on insulator ») comprenant un substrat 6 surmonté d'une couche isolante 61 et d'une couche semi-conductrice.

Cette couche semi-conductrice est de préférence dopée de type « P ».

Une implantation ionique en surface de cette couche semi-conductrice peut être réalisée de manière à obtenir une portion supérieure présentant un dopage de type « N ». Une interface continue de type jonction PN est ainsi créée entre la portion supérieure et une portion inférieure sous-jacente de la couche semi-conductrice.

Des étapes de lithographie et gravure de la couche semi-conductrice permettent ensuite de former de préférence des ilots séparés et isolés les uns des autres, comprenant chacun une superposition des portions inférieure et supérieure de la couche semi-conductrice. Des contacts métalliques supérieurs et inférieurs peuvent être respectivement déposés sur les portions supérieures et inférieures de chaque ilot.

Dès lors, chaque ilot forme une cellule photovoltaïque présentant une face avant formée par la portion supérieure.

Ces cellules photovoltaïques peuvent être reliées entre elles de sorte à former une matrice de cellules photovoltaïques. En particulier, le contact supérieur d'une cellule photovoltaïque peut être relié au contact inférieur d'une cellule photovoltaïque adjacente, de manière à connecter les cellules photovoltaïques de la matrice 3 en série.

Selon un mode de réalisation illustré à la figure 1, la connexion entre les cellules photovoltaïques de la matrice 3 peut se faire par l'intermédiaire de vias traversants 600 formés au travers du substrat 6.

Les cellules photovoltaïques sont dès lors interconnectées par la face arrière 62. L'avantage de ce mode de réalisation est notamment qu'il permet d'éliminer un ombrage des cellules photovoltaïques dû à des contacts en face avant.

Pour former les vias traversants 600, une gravure profonde peut être réalisée à partir de la face arrière 62 de manière à former des ouvertures sous la base des ilots.

Chaque ilot est de préférence associé à au moins deux ouvertures, possiblement dix, de préférence huit.

Un isolant peut être déposé puis gravé de manière anisotrope de manière à chemiser les flancs verticaux des ouvertures.

Ensuite, une implantation peut être réalisée par la face arrière sur une moitié des ouvertures afin de doper, de type N+, des premières zones 31 de la portion inférieure de la couche semi-conductrice. Chaque ilot est ainsi associé à une ouverture se prolongeant par une implantation de type N.

Une seconde implantation peut être réalisée de manière similaire sur l'autre moitié des ouvertures afin de doper, de type P+, des deuxièmes zones 32 de la portion inférieure de la couche semi-conductrice. Chaque ilot est ainsi associé à une ouverture se prolongeant par une implantation de type P.

Les ouvertures peuvent être ensuite remplies par un matériau conducteur par la face arrière afin de former des vias traversants de type « TSV last ».

La formation d'interconnexions 300 sur la face arrière 62, par exemple par une technique de « lift-off », ou par lithographie et gravure, permet de relier les vias traversants 600 entre eux.

Dans le cadre de la présente demande de brevet, d'autres modes de réalisation des cellules photovoltaïques sont envisageables, en particulier les modes de réalisation décrits dans le brevet US 9,647,161.

D'autres configurations de matrices de cellules photovoltaïques 3, bien connues de l'homme du métier, peuvent également être utilisées et intégrées dans l'optocoupleur 1.

La réception du signal lumineux par les cellules photovoltaïques peut se faire à partir d'une surface tournée en regard de la matrice de diodes laser 2.

Cette surface peut être une face supérieure 33 du deuxième étage de conversion après formation et/ou report de la matrice 2 sur la matrice 3.

Selon un mode de réalisation préféré, les cellules photovoltaïques sont de préférence formées ou reportées en face avant de la puce 6. Elles peuvent être séparées entre elles et en partie isolées les unes des autres par l'intermédiaire d'une couche d'oxyde superficielle 61 par exemple.

Les cellules photovoltaïques sont de préférence reliées les unes aux autres en série et peuvent délivrer le signal électrique de sortie par l'intermédiaire de deux connexions de sortie 371. Cette configuration est illustrée en figure 1.

Deux cellules photovoltaïques adjacentes peuvent être interconnectées par l'intermédiaire d'interconnexions 300 reliant la première zone de type N 31 de l'une des deux cellules photovoltaïques adjacentes à la deuxième zone de type P 32 de l'autre des deux cellules photovoltaïques adjacentes.

Ces interconnexions 300 peuvent être réalisées en face arrière de la puce 6 par l'intermédiaire de vias traversants 600 formés dans la puce 6.

Selon le mode de réalisation non limitatif illustré en figure 1, la face arrière 62 de la puce 6 est fixée sur un support 5. La face avant de la puce porte les cellules de la matrice de cellules photovoltaïques 3. De préférence, la matrice de cellules photovoltaïques 3 est disposée directement au contact de la couche isolante 61 de la puce 6.

La face supérieure 33 de la matrice de cellules photovoltaïques 3 est disposée de préférence directement au contact de la face inférieure de la couche transparente 230. La face supérieure de la couche transparente 230 est disposée de préférence directement au contact de la face avant 21 de la matrice de diodes laser 2.

Comme illustré en figure 2B, un motif en chevron peut par exemple permettre de relier les connexions de type N 31 aux connexions de type P 32 de deux cellules photovoltaïques adjacentes.

Cette deuxième conversion permet d'obtenir un signal électrique de sortie au niveau des connexions de sortie 371.

Selon une possibilité illustrée en figure 2A les connexions de sortie 371 peuvent être au nombre de deux.

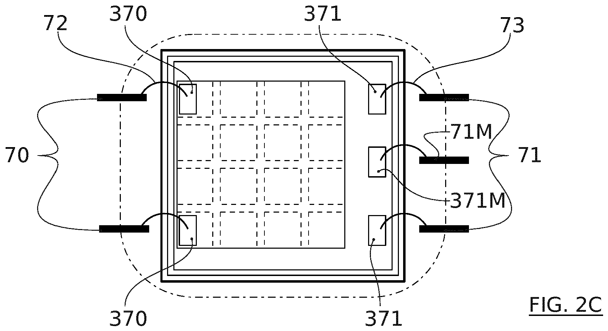

Comme illustré en figure 2C, selon une autre possibilité les connexions de sortie 371, 371m peuvent être au nombre de trois. Dans ce cas, la troisième connexion de sortie 371M correspond de préférence à un point milieu, c'est-à-dire un point situé entre les premières et deuxièmes connexions 371.

Cette possibilité permet de délivrer un signal électrique de sortie variant entre deux valeurs opposées de tension sur chacune des connexions de sortie 371, par rapport à une tension de référence sur la troisième connexion de sortie 371M, à la masse ou à 0V par exemple.

Selon une possibilité, une première connexion de sortie 371 coopère avec un premier nombre de cellules photovoltaïques et une deuxième connexion de sortie 371 coopère avec un deuxième nombre de cellules photovoltaïques différent du premier nombre. Cela permet de délivrer des premier et deuxième signaux électriques de sortie respectivement sur les première et deuxième connexions de sortie 371, différents entre eux. En particulier ces premier et deuxième signaux électriques de sortie peuvent présenter des tensions de signes opposés relativement au point milieu, et différentes en valeur absolue.

Selon une autre possibilité, le nombre de connexions de sortie 371 autres que celle à point milieu 371M est supérieur à 2. Ce nombre de connexions de sortie 371 autres que celle à point milieu 371M peut être supérieur à 3.

Ces connexions de sortie 371 peuvent ainsi délivrer une pluralité de signaux de sortie présentant différentes valeurs de tensions positives et négatives par rapport au point milieu. Ces valeurs de tensions peuvent être choisies arbitrairement.

La deuxième conversion peut présenter un rendement de conversion de l'ordre de 15% à 25%.

Le système de conversion peut notamment comprendre une couche transparente 230 d'épaisseur comprise entre quelques centaines de nanomètres et quelques micromètres. Cette épaisseur peut être avantageusement choisie en fonction de la longueur d'onde des diodes laser de la matrice 2, de manière à optimiser le couplage optique du système de conversion.

La couche transparente 230 peut être par exemple une couche adhésive en silicone ou silicone/époxy. Une telle couche transparente 230 adhésive permet avantageusement d'assembler et/ou de fixer la matrice de diodes laser 2 sur les cellules photovoltaïques de la matrice 3.

La matrice de diodes laser 2 est de préférence configurée pour éclairer directement la matrice de cellules photovoltaïques 3.

En particulier, chaque diode laser de la matrice 2 peut être dimensionnée et agencée de façon à éclairer chaque cellule photovoltaïque correspondante de la matrice 3.

La surface totale d'émission peut être inférieure ou égale à la surface totale de réception.

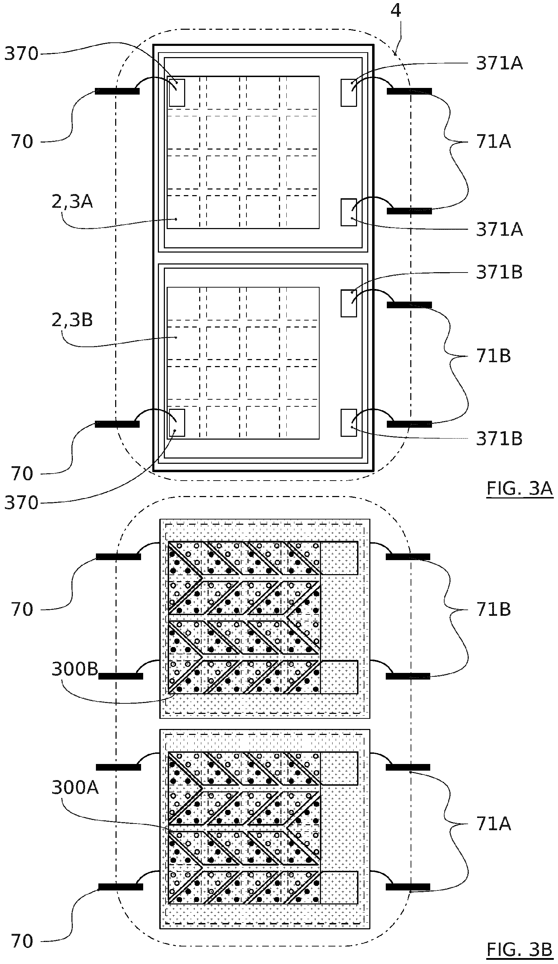

Selon une possibilité alternative illustrée aux figures 3A, 3B, deux matrices indépendantes de cellules photovoltaïques 3A, 3B peuvent être couplées à une seule matrice de diodes laser 2. Dans ce cas, le signal électrique d'entrée transmis entre les deux connexions d'entrée 370 peut être avantageusement dédoublé en deux signaux électriques de sortie délivrés respectivement entre deux connexions de sortie 371A et deux connexions de sortie 371B, par l'intermédiaire de deux systèmes d'interconnexion 300A, 300B distincts. Selon cette possibilité, la surface totale d'émission peut être supérieure à la surface totale de réception.

Selon une possibilité préférée, l'optocoupleur 1 comprend donc les connexions d'entrée 370 reliées à la matrice de diodes laser 2 reportée sur et séparée d'au moins une matrice de cellules photovoltaïques 3, 3A, 3B par la couche transparente 230 adhésive. L'au moins une matrice de cellules photovoltaïques 3, 3A, 3B est formée sur la puce 6. Elle est reliée aux connexions de sortie 371, 371A, 371B par l'intermédiaire des vias traversants et des interconnexions 300, 300A, 300B.

Un tel optocoupleur 1 peut être assemblé sur une grille de connexion 5 par l'intermédiaire d'une couche de fixation 560. Cette couche de fixation 560 peut être par exemple une colle époxy ou résulter d'une brasure.

L'optocoupleur 1 fixé sur la grille de connexion 5 peut être assemblé dans un boîtier 4 traversé en partie par des pattes ou des broches d'entrée 70 et de sortie 71.

En particulier, les connexions d'entrée 370 peuvent être reliées aux broches d'entrée 70 par l'intermédiaire de fils de connexion 72, tel qu'illustré en figure 1. Selon les cas, les connexions de sortie 371, 371A, 371B, 371M peuvent être reliées aux broches de sortie 71, 71A, 71B, 71M par l'intermédiaire de fils de connexion 73.

Le boîtier 4 entourant la grille de connexion 5, l'optocoupleur 1 et les fils de connexion 72, 73 peut être plein, de type époxy, ou à cavité.

Les broches d'entrée 70 et de sortie 71, le boîtier 4 comprenant la grille de connexion 5, l'optocoupleur 1 et les fils de connexion 72, 73 forment de préférence un système d'optocoupleur.

Ce système d'optocoupleur peut dès lors former un module de base pouvant être avantageusement utilisé pour isoler différentes parties d'un convertisseur.

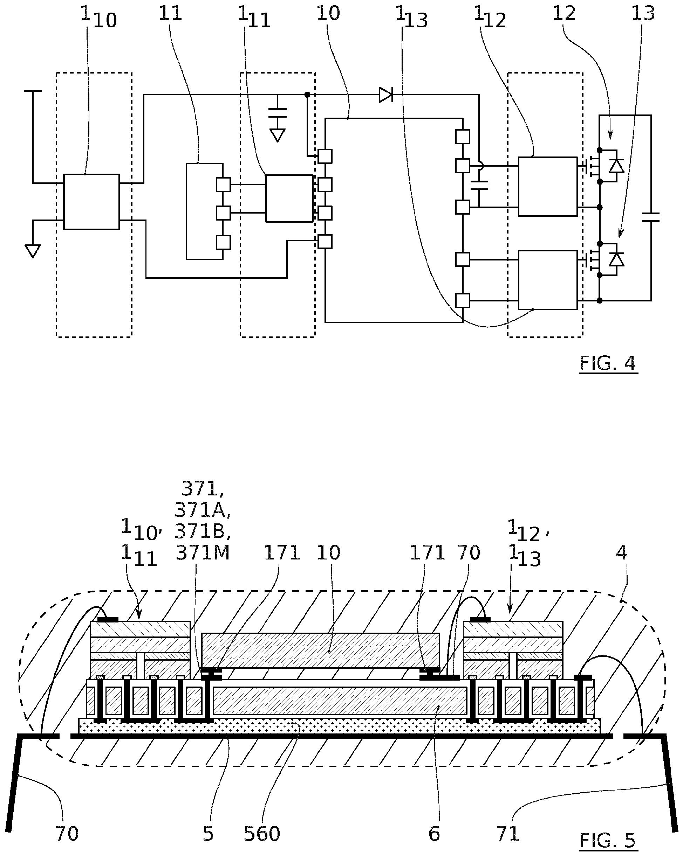

Dans la suite, un exemple d'utilisation d'un tel module de base illustré à la figure 4 concerne l'isolation d'un onduleur.

Cet exemple n'est pas limitatif et peut être adapté *mutatis mutandis* à tous types de convertisseurs tels que, par exemple, un redresseur, un hacheur, un convertisseur AC/AC, un convertisseur DC/DC. Cette liste n'est cependant pas exhaustive.

Un onduleur peut comprendre un bras d'onduleur connecté à une source de signal à convertir, et un circuit électronique de commande 10 de ce bras d'onduleur.

Le bras d'onduleur peut être typiquement formé par deux transistors de puissance 12, 13.

Le circuit électronique de commande, simplement dénommé circuit de commande 10, est alimenté par une alimentation électrique et piloté par des signaux d'entrée par exemple de type PWM (Pulse Width Modulation) issu d'un contrôleur 11.

Il commande chacun des transistors 12, 13 du bras d'onduleur.

Selon une possibilité, un premier module optocoupleur 1₁₀ peut isoler le circuit de commande 10 de l'alimentation électrique.

Ce premier module optocoupleur 1₁₀ entre une alimentation électrique fournissant par exemple une puissance électrique de 6W et un circuit de commande 10 nécessitant par exemple une alimentation sous environ 30V et 18mA, peut être dimensionné comme suit :
La matrice de diodes laser 2 reliée à l'alimentation électrique peut fournir une puissance lumineuse de 4 W environ à partir du signal électrique d'entrée présentant une puissance électrique de 6W (la première conversion présente par exemple un rendement de conversion de 66% environ).

Chacune des cellules photovoltaïques de la matrice 3 peut délivrer environ 0,4 V sous une puissance lumineuse de 4 W (la deuxième conversion présente par exemple un rendement de conversion de 15% environ).

Dès lors, la matrice de cellules photovoltaïques 3 peut comprendre 81 cellules photovoltaïques de façon à délivrer au total 81 X 0,4 V = 32,4 V et 19 mA pour le signal électrique de sortie. Ce signal électrique de sortie peut donc avantageusement alimenter électriquement le circuit de commande 10.

Selon une possibilité, un deuxième module optocoupleur 1₁₁ peut isoler le circuit de commande 10 du contrôleur 11.

Ce deuxième module optocoupleur 1₁₁ entre un contrôleur 11 fournissant par exemple une puissance électrique de 0,5W (10V à 50 mA) et un circuit de commande 10 nécessitant par exemple un signal PWM compris entre 0V et 5V sous 15µA, peut être dimensionné comme suit :
La matrice de diodes laser 2 reliée au contrôleur 11 peut fournir une puissance lumineuse de 330 mW environ à partir du signal PWM délivré par le contrôleur 11 d'une puissance électrique de 0,5W (la première conversion présente par exemple un rendement de conversion de 66% environ). Cette puissance lumineuse est largement supérieure à la puissance lumineuse requise (500µW) pour délivrer un signal électrique de sortie compris entre 0V et 5V sous 15µA, en considérant une deuxième conversion présentant par exemple un rendement de conversion de 15% environ.

Chacune des cellules photovoltaïques de la matrice 3 peut en effet délivrer environ 0,3 V sous une puissance lumineuse de 500µW.

Dès lors, la matrice de cellules photovoltaïques 3 peut comprendre 16 cellules photovoltaïques de façon à délivrer au total 16 X 0,3 V = 4,8 V et 15 µA pour le signal électrique de sortie. Ce signal électrique de sortie peut donc avantageusement piloter le circuit de commande 10.

Selon une possibilité, des troisième et quatrième modules optocoupleur 1₁₂, 1₁₃ peuvent isoler le circuit de commande 10 des transistors 12 et 13 du bras d'onduleur respectivement.

Pour un circuit de commande 10 pouvant délivrer des signaux de commande de 56V et 100 mA (5,6W), ces troisième et quatrième modules optocoupleur 1₁₂, 1₁₃ peuvent chacun être dimensionnés comme suit :
La matrice de diodes laser 2 reliée au circuit de commande 10 peut fournir une puissance lumineuse de 3,7W environ à partir du signal de commande délivré par le circuit de commande 10 d'une puissance électrique de 5,6W (la première conversion présente par exemple un rendement de conversion de 66% environ).

Chacune des cellules photovoltaïques de la matrice 3 peut délivrer environ 0,4 V sous une puissance lumineuse de 3,7W (la deuxième conversion présente par exemple un rendement de conversion de 15% environ).

Dès lors, la matrice de cellules photovoltaïques 3 peut comprendre 16 cellules photovoltaïques de façon à délivrer au total 16 X 0,4 V = 6 V et 90 mA pour le signal électrique de sortie.

Les signaux électriques de sortie des troisième et quatrième modules optocoupleur 1₁₂, 1₁₃ peuvent donc avantageusement commander les transistors 12,13 du bras d'onduleur.

On pourra naturellement prévoir, pour un même onduleur, de n'avoir qu'un seul optocoupleur parmi les optocoupleurs 1₁₀, 1₁₁, 1₁₂, 1₁₃, ou d'en avoir plusieurs, voire de les avoir tous.

Le système d'optocoupleur peut être associé à un circuit intégré électronique 10 pour former un module intégré. Selon un exemple particulier, ce module intégré peut avantageusement comprendre différentes parties d'un convertisseur.

Dans la suite, un exemple non limitatif d'un tel module intégré concerne l'isolation du circuit de commande 10 d'un onduleur. Néanmoins, l'invention couvre les cas dans lesquels le circuit intégré électronique n'est pas un circuit de commande.

Ce module illustré à la figure 5 peut par exemple comprendre des premier et deuxième optocoupleurs ayant la même fonction d'isolation que les premier et deuxième modules optocoupleur 1₁₀, 1₁₁, et dénommés par contraction dans la suite optocoupleurs 1₁₀, 1₁₁. Ce module peut également comprendre des troisième et quatrième optocoupleurs ayant la même fonction d'isolation que les troisième et quatrième modules optocoupleur 1₁₂, 1₁₃, et dénommés par contraction dans la suite optocoupleurs 1₁₂, 1₁₃.

Par exemple, les optocoupleurs 1₁₀, 1₁₁, 1₁₂, 1₁₃ peuvent être fabriqués et/ou assemblés sur une même puce 6 en étant isolés les uns des autres. Cette puce 6 peut être collée ou soudée sur un support 5, préférentiellement sur une grille de connexion 5, et le circuit de commande 10 peut être retourné et reporté sur la puce 6.

Diverses techniques de report et de connexion bien connues de l'homme du métier et de pratique courante dans l'industrie de la microélectronique peuvent être employées afin de connecter le circuit de commande 10 et les optocoupleurs 1₁₀, 1₁₁, 1₁₂, 1₁₃.

En particulier, les techniques dites « flipchip » (puce retournée en français) et « wire-bonding » (câblage par fil en français) peuvent être mises en oeuvre.

Avantageusement, le circuit de commande 10 est fabriqué indépendamment des optocoupleurs 1₁₀, 1₁₁, 1₁₂, 1₁₃ comprenant le substrat 6. Le circuit de commande 10 peut être fabriqué avant, pendant ou après la fabrication des optocoupleurs 1₁₀, 1₁₁, 1₁₂, 1₁₃. Il peut être mécaniquement rapporté dans un boîtier 4 comprenant les optocoupleurs et électriquement connecté à ces derniers.

Typiquement le circuit de commande 10 comprend des plots de contact 171. Dans l'exemple illustré à la figure 5, les plots de contact 171 portés par le circuit de commande 10 sont par exemple des pad ou des billes métalliques, par exemple en indium ou en étain ou en cuivre, ou en alliage de cuivre, argent et étain. Ils sont par exemple aptes à fondre ou à adhérer aux connexions 371, 371A, 371B, 371M, 70 par refusion.

Les entrées du circuit de commande 10 peuvent dès lors être connectées par l'intermédiaire des plots de connexion 171 au niveau des connexions de sortie 371, 371A, 371 B, 371M des optocoupleurs 1₁₀, 1₁₁, en fonction du type d'optocoupleur 1 choisi.

Les sorties du circuit de commande 10 peuvent dès lors être connectées par l'intermédiaire des plots de connexion 171 au niveau des connexions d'entrée 70 des optocoupleurs 1₁₂, 1₁₃.

On obtient ainsi une partie de convertisseur comprenant le circuit de commande 10 et l'isolation par optocoupleurs 1₁₀, 1₁₁, 1₁₂, 1₁₃ d'une manière simple et reproductible et sans pour autant que la fabrication des optocoupleurs n'ait été contrainte par la fabrication du circuit de commande 10.

Le boîtier 4 entourant la grille de connexion 5, les optocoupleurs 1₁₀, 1₁₁, 1₁₂, 1₁₃ et le circuit de commande 10 peut être plein, de type époxy, ou à cavité (pour favoriser la dissipation thermique du convertisseur de puissance par exemple).

L'intégration de l'optocoupleur comprenant les cellules photovoltaïques de la matrice 3 avec le circuit intégré électronique, par exemple le circuit de commande 10, peut être réalisée selon les procédés décrits dans le document US 9,647,161. On notera que dans ce document, les cellules photovoltaïques servent à alimenter le circuit intégré électronique. Dans ce document, les cellules photovoltaïques n'ont aucunement comme fonction de former une partie d'un optocoupleur. A fortiori, ce document n'envisage aucunement que les cellules photovoltaïques forment une partie d'une isolation d'un circuit de commande d'un convertisseur.

Comme indiqué dans ce document, après avoir fabriqué l'empilement comprenant la matrice de cellules photovoltaïques 3 et possiblement la matrice de diodes laser 2 séparément du circuit intégré électronique 10, on reporte le circuit intégré électronique 10 sur l'empilement. Lors de ce report, on met en contact des zones de connexion portées par la matrice de cellules photovoltaïques 3 avec des zones de connexion correspondantes portées par le circuit intégré électronique 10.

Selon un mode de réalisation, ce procédé d'intégration comprend les étapes suivantes :
- après l'étape de réalisation de la matrice de cellules photovoltaïques 3, on effectue un cycle d'étapes de connexion comprenant au moins la réalisation d'au moins une zone d'accueil 371, 371A, 371B, 371M, 70 destinées à relier électriquement les cellules photovoltaïques avec le circuit intégré électronique 10.
- après le cycle d'étapes de connexion, on effectue une étape de report, sur l'empilement, du circuit intégré électronique 10 préalablement fabriqué. L'étape de report est effectuée de manière à connecter électriquement l'au moins une zone d'accueil 371, 371A, 371B, 371M, 70 avec une zone de contact électrique 171 portée par le circuit intégré électronique 10.
Ce mode de réalisation, permet de fabriquer séparément le dispositif photovoltaïque et le circuit intégré 10 puis de les assembler sans lourdement complexifier le procédé de fabrication. La fabrication de la matrice de cellules photovoltaïques 3 n'est donc pas contrainte par la fabrication du circuit intégré 10. On peut ainsi fabriquer des cellules plus performantes. Dans les solutions conventionnelles les cellules photovoltaïques sont réalisées par lithographie de couches successivement déposées sur le circuit intégré, typiquement à partir d'une face avant de ce dernier.

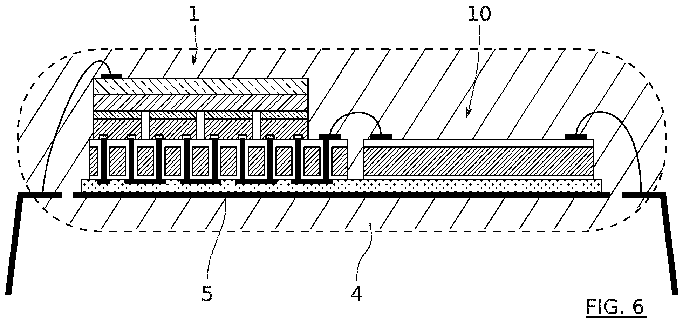

Selon un autre exemple illustré à la figure 6, ce module peut ne comprendre qu'un seul optocoupleur 1, par exemple de façon à isoler le circuit de commande 10 en entrée seulement. D'autres dispositions du ou des optocoupleurs 1 sont naturellement envisageables, par exemple pour isoler le circuit de commande 10 en sortie seulement.

L'invention n'est pas limitée aux modes de réalisations précédemment décrits et s'étend à tous les modes de réalisation couverts par les revendications.

## Revendications

1. Optocoupleur (1) comprenant au moins une source lumineuse (2) et au moins un récepteur (3) en regard de l'au moins une source lumineuse (2), ladite au moins une source lumineuse (2) étant une matrice de diodes laser et étant configurée pour recevoir en entrée un signal électrique d'entrée, et générer en sortie en fonction dudit signal électrique d'entrée au moins un signal lumineux à destination de l'au moins un récepteur (3), l'au moins un récepteur (3) étant une matrice de cellules photovoltaïques et étant configuré pour recevoir en entrée au moins en partie le signal lumineux et pour délivrer en sortie au moins un signal électrique de sortie, la matrice de cellules photovoltaïques et la matrice de diodes laser s'étendant principalement dans des plans parallèles et étant disposées en regard l'une de l'autre, l'optocoupleur (1) étant **caractérisé en ce que** le signal électrique de sortie est délivré par l'au moins un récepteur (3) au niveau de trois connexions de sortie (371, 371m) agencées de manière à former une connexion à point milieu.

2. Optocoupleur (1) selon la revendication 1 dans lequel la matrice de diodes laser (2) émet une lumière monochromatique présentant une longueur d'onde comprise entre 500 nm et 600 nm.

3. Optocoupleur (1) selon l'une quelconque des revendications précédentes dans lequel une partie au moins des cellules photovoltaïques (3) de l'au moins une matrice de cellules photovoltaïques (3) sont des cellules photovoltaïques à base de gallium.

4. Optocoupleur (1) selon l'une quelconque des revendications précédentes dans lequel la matrice de diodes laser (2) comprend un nombre de diodes laser inférieur ou égal au nombre de cellules photovoltaïques de l'au moins une matrice de cellules photovoltaïques (3).

5. Optocoupleur (1) selon l'une quelconque des revendications précédentes dans lequel la matrice de diodes laser (2) comprend des diodes laser à cavité verticale émettant par la surface VCSEL (acronyme de « vertical-cavity surface-emitting laser »).

6. Optocoupleur (1) selon l'une quelconque des revendications précédentes comprenant une pluralité de matrices de cellules photovoltaïques (3a, 3b) et dans lequel la matrice de diodes laser (2) est configurée pour délivrer le signal lumineux à destination de la pluralité de matrices de cellules photovoltaïques (3a, 3b), ladite pluralité de matrices de cellules photovoltaïques (3a, 3b) étant configurée pour délivrer en sortie une pluralité de signaux électriques de sortie.

7. Optocoupleur (1) selon l'une quelconque des revendications précédentes comprenant un boîtier (4) à l'intérieur duquel est intégré l'au moins une source lumineuse (2) et l'au moins une matrice de cellules photovoltaïques (3).

8. Système d'optocoupleur comprenant un boîtier (4), un support (5), au moins une puce (6) assemblée sur le support (5), et au moins un optocoupleur (1) selon l'une quelconque des revendications précédentes reporté sur ladite puce (6), l'au moins un optocoupleur (1), l'au moins une puce (6) et le support (5) étant situés dans le boîtier (4).

9. Système selon la revendication 8 comprenant en outre un circuit électronique de commande (10), par exemple d'un bras d'onduleur, et comprenant au moins un premier optocoupleur (1₁₀, 1₁₁) selon l'une quelconque des revendications 1 à 7, et au moins un deuxième optocoupleur (1₁₂, 1₁₃) selon l'une quelconque des revendications 1 à 7, le circuit électronique (10) présentant une entrée connectée au premier optocoupleur (1₁₀, 1₁₁) et une sortie connectée au deuxième optocoupleur (1₁₂, 1₁₃), et dans lequel lesdits au moins premier et deuxième optocoupleurs (1₁₀, 1₁₁, 1₁₂, 1₁₃), le circuit électronique (10) et le support (5) sont situés dans le boîtier (4).

10. Système selon la revendication précédente dans lequel lesdits au moins premier et deuxième optocoupleurs (1₁₀, 1₁₁, 1₁₂, 1₁₃) et le circuit électronique (10) sont reportés sur une même puce (6).

11. Système selon l'une des revendications 9 à 10 dans lequel le circuit électronique (10) est un circuit de commande d'un bras d'onduleur.

12. Système selon la revendication précédente dans lequel le circuit de commande présente une entrée d'alimentation connectée à une sortie d'un optocoupleur (1, 1₁₀) selon l'une quelconque des revendications 1 à 7, l'optocoupleur (1, 1₁₀) étant connecté en entrée à une alimentation électrique.

13. Système selon l'une des deux revendications précédentes dans lequel le circuit de commande présente une entrée de contrôle connectée à une sortie d'un optocoupleur (1, 1₁₁) selon l'une quelconque des revendications 1 à 7, l'optocoupleur (1, 1₁₁) étant connecté en entrée à un contrôleur (11).

14. Système selon l'une des trois revendications précédentes dans lequel le circuit de commande présente une première sortie connectée à une entrée d'un premier optocoupleur (1₁₂) selon l'une quelconque des revendications 1 à 7, le premier optocoupleur (1₁₂) étant connecté en sortie à un premier transistor (12) d'un bras d'onduleur, et dans lequel le circuit de commande présente une deuxième sortie connectée à une entrée d'un deuxième optocoupleur (1₁₃) selon l'une quelconque des revendications 1 à 7, le deuxième optocoupleur (1₁₃) étant connecté en sortie à un deuxième transistor (13) dudit bras d'onduleur.

15. Appareil intégrant un système selon l'une quelconque des revendications 8 à 10, l'appareil étant pris parmi :
- les alimentations à découpage,
- les convertisseurs AC/AC, AC/DC, DC/DC,
- les appareils de transmission de données numériques isolées,
- les appareils de pilotage de charges.

## Patentansprüche

1. Optokoppler (1), umfassend mindestens eine Lichtquelle (2) und mindestens einen Empfänger (3), der der mindestens einen Lichtquelle (2) zugewandt ist, wobei die mindestens eine Lichtquelle (2) eine Laserdiodenmatrix ist und ausgelegt ist, um am Eingang ein elektrisches Eingangssignal zu empfangen und am Ausgang in Abhängigkeit von dem elektrischen Eingangssignal mindestens ein Lichtsignal in Richtung des mindestens einen Empfängers (3) zu erzeugen, wobei der mindestens eine Empfänger (3) eine Photovoltaikzellenmatrix ist und ausgelegt ist, um am Eingang mindestens teilweise das Lichtsignal zu empfangen und am Ausgang mindestens ein elektrisches Ausgangssignal bereitzustellen, wobei sich die Photovoltaikzellenmatrix und die Laserdiodenmatrix hauptsächlich in parallelen Ebenen erstrecken und einander zugewandt angeordnet sind, wobei der Optokoppler (1) **dadurch gekennzeichnet ist, dass** das elektrische Ausgangssignal von dem mindestens einen Empfänger (3) im Bereich von drei Ausgangsanschlüssen (371, 371m) bereitgestellt wird, die derart eingerichtet sind, dass ein Anschluss mit Mittelpunkt gebildet wird.

2. Optokoppler (1) nach Anspruch 1, wobei die Laserdiodenmatrix (2) ein monochromatisches Licht sendet, das eine Wellenlänge aufweist, die zwischen 500 nm und 600 nm liegt.

3. Optokoppler (1) nach einem der vorangehenden Ansprüche, wobei mindestens ein Teil der Photovoltaikzellen (3) der mindestens einen Photovoltaikzellenmatrix (3) Photovoltaikzellen auf der Basis von Gallium sind.

4. Optokoppler (1) nach einem der vorangehenden Ansprüche, wobei die Laserdiodenmatrix (2) eine Anzahl von Laserdioden umfasst, die kleiner oder gleich der Anzahl von Photovoltaikzellen der mindestens einen Photovoltaikzellenmatrix (3) ist.

5. Optokoppler (1) nach einem der vorangehenden Ansprüche, wobei die Laserdiodenmatrix (2) Laserdioden mit vertikaler Kavität umfasst, die über die VCSEL-Fläche (Abkürzung von "vertical-cavity surface-emitting laser") senden.

6. Optokoppler (1) nach einem der vorangehenden Ansprüche, umfassend eine Vielzahl von Photovoltaikzellenmatrizes (3a, 3b) umfasst und wobei die Laserdiodenmatrix (2) ausgelegt ist, um das Lichtsignal in Richtung der Vielzahl von Photovoltaikzellenmatrizes (3a, 3b) bereitzustellen, wobei die Vielzahl von Photovoltaikzellenmatrices (3a, 3b) ausgelegt ist, um am Ausgang eine Vielzahl von elektrischen Ausgangssignalen bereitzustellen.

7. Optokoppler (1) nach einem der vorangehenden Ansprüche, umfassend ein Gehäuse (4), in dessen Inneren die mindestens eine Lichtquelle (2) und die mindestens eine Photovoltaikzellenmatrix (3) integriert sind.

8. Optokopplersystem, umfassend ein Gehäuse (4), einen Träger (5), mindestens einen auf dem Träger (5) aufgebrachten Chip (6) und mindestens einen Optokoppler (1) nach einem der vorangehenden Ansprüche, der auf den Chip (6) gesetzt ist, wobei sich der mindestens eine Optokoppler (1), der mindestens eine Chip (6) und der Träger (5) in dem Gehäuse (4) befinden.

9. System nach Anspruch 8, umfassend ferner einen elektronischen Steuerkreis (10), beispielsweise eines Wechselrichterarms, und umfassend mindestens einen ersten Optokoppler (1₁₀, 1₁₁) nach einem der Ansprüche 1 bis 7 und mindestens einen zweiten Optokoppler (1₁₂, 1₁₃) nach einem der Ansprüche 1 bis 7, wobei der elektronische Kreis (10) einen Eingang aufweist, der an den ersten Optokoppler (1₁₀, 1₁₁) angeschlossen ist, und einen Ausgang, der an den zweiten Optokoppler (1₁₂, 1₁₃), angeschlossen ist und wobei sich der mindestens erste und zweite Optokoppler (1₁₀, 1₁₁, 1₁₂, 1₁₃), der elektronische Kreis (10) und der Träger (5) im Gehäuse (4) befinden.

10. System nach vorangehendem Anspruch, wobei der mindestens erste und zweite Optokoppler (1₁₀, 1₁₁, 1₁₂, 1₁₃) und der elektronische Kreis (10) auf denselben Chip (6) gesetzt sind.

11. System nach einem der Ansprüche 9 bis 10, wobei der elektronische Kreis (10) ein Steuerkreis eines Wechselrichterarms ist.

12. System nach vorangehendem Anspruch, wobei der Steuerkreis einen Versorgungseingang aufweist, der an einen Ausgang eines Optokopplers (1, 1₁₀) nach einem der Ansprüche 1 bis 7 angeschlossen ist, wobei der Optokoppler (1, 1₁₀) am Eingang an eine elektrische Versorgung angeschlossen ist.

13. System nach einem der zwei vorangehenden Ansprüche, wobei der Steuerkreis einen Kontrolleingang aufweist, der an einen Ausgang eines Optokopplers (1, 1₁₁) nach einem der Ansprüche 1 bis 7 angeschlossen ist, wobei der Optokoppler (1, 1₁₁) am Eingang an einen Controller (11) angeschlossen ist.

14. System nach einem der drei vorangehenden Ansprüche, wobei der Steuerkreis einen ersten Ausgang aufweist, der an einen Eingang eines ersten Optokopplers (1₁₂) nach einem der Ansprüche 1 bis 7 angeschlossen ist, wobei der erste Optokoppler (1₁₂) am Ausgang an einen ersten Transistor (12) eines Wechselrichterarms angeschlossen ist, und wobei der Steuerkreis einen zweiten Ausgang aufweist, der an einen Eingang eines zweiten Optokopplers (1₁₃) nach einem der Ansprüche 1 bis 7 angeschlossen ist, wobei der zweite Optokoppler (1₁₃) am Ausgang an einen zweiten Transistor (13) des Wechselrichterarms angeschlossen ist.

15. Gerät, das ein System nach einem der Ansprüche 8 bis 10 integriert, wobei das Gerät ausgewählt ist aus:
- den Schaltnetzteilen,
- den AC/AC-, AC/DC-, DC/DC-Wandlern,
- den Geräten zur Übertragung isolierter digitaler Daten,
- den Geräten zur Steuerung von Lasten.

## Claims

1. Optocoupler (1) comprising at least one light source (2) and at least one receiver (3) facing the at least one light source (2), said at least one light source (2) being a laser diode matrix and being configured to receive, at the input, an electric input signal, and generate, at the output, according to said electric input signal, at least one light signal sent to the at least one receiver (3), the at least one receiver (3), being a photovoltaic cell matrix and being configured to receive, at the input, at least partially the light signal and to deliver at the output, at least one electric output signal, the photovoltaic cell matrix and the laser diode matrix extending mainly in parallel planes and being arranged facing one another, the optocoupler (1) being **characterised in that** the electric output signal is delivered by the at least one receiver (3) at the level of three output connections (371, 371m) arranged so as to form a connection at the middle point.

2. Optocoupler (1) according to claim 1, wherein the laser diode matrix (2) emits a monochrome light having a wavelength comprised between 500nm and 600nm.

3. Optocoupler (1) according to any one of the preceding claims, wherein at least some of the photovoltaic cells (3) of the at least one photovoltaic cell matrix (3) are gallium-based photovoltaic cells.

4. Optocoupler (1) according to any one of the preceding claims, wherein the laser diode matrix (2) comprises a number of laser diodes less than or equal to the number of photovoltaic cells of the at least one photovoltaic cell matrix (3).

5. Optocoupler (1) according to any one of the preceding claims, wherein the laser diode matrix (2) comprises a vertical-cavity surface-emitting laser VCSEL.

6. Optocoupler (1) according to any one of the preceding claims comprising a plurality of photovoltaic cell matrices (3a, 3b) and wherein the laser diode matrix (2) is configured to deliver the light signal sent to the plurality of photovoltaic cell matrices (3a, 3b), said plurality of photovoltaic cell matrices (3a, 3b) being configured to deliver, at the output, a plurality of electric output signals.

7. Optocoupler (1) according to any one of the preceding claims comprising a casing (4) inside which is integrated the at least one light source (2) and the at least one photovoltaic cell matrix (3).

8. Optocoupler system comprising a casing (4), a support (5), at least one chip (6) assembled on the support (5), and at least one optocoupler (1) according to any one of the preceding claims, carried over on said chip (6), the at least one optocoupler (1), the at least one chip (6) and the support (5) being situated in the casing (4).

9. System according to claim 8 further comprising an electronic command circuit (10), for example an inverter arm, and comprising at least one first optocoupler (1₁₀, 1₁₁) according to any one of claims 1 to 7, and at least one second optocoupler (1₁₂, 1₁₃) according to any one of claims 1 to 7, the electronic circuit (10) having an input connected to the first optocoupler (1₁₀, 1₁₁) and an output connected to the second optocoupler (1₁₂, 1₁₃), and wherein said at least first and second optocouplers (1₁₀, 1₁₁, 1₁₂, 1₁₃), the electronic circuit (10) and the support (5) are situated in the casing (4).

10. System according to the preceding claim, wherein said at least first and second optocouplers (1₁₀, 1₁₁, 1₁₂, 1₁₃) and the electronic circuit (10) are carried over on one same chip (6).

11. System according to one of claims 9 to 10, wherein the electronic circuit (10) is a circuit for commanding an inverter arm.

12. System according to the preceding claim, wherein the command circuit has a power input connected to an output of an optocoupler (1, 1₁₀) according to any one of claims 1 to 7, the optocoupler (1, 1₁₀) being connected at the input to an electric supply.

13. System according to one of the two preceding claims, wherein the command circuit has a control input connected to an output of an optocoupler (1, 1₁₁) according to any one of claims 1 to 7, the optocoupler (1, 1₁₁) being connected at the input to a controller (11).

14. System according to one of the three preceding claims, wherein the command circuit has a first output connected to an input of a first optocoupler (1₁₂) according to any one of claims 1 to 7, the first optocoupler (1₁₂) being connected at the output to a first transistor (12) of an inverter arm, and wherein the command circuit has a second output connected to an input of a second optocoupler (1₁₃) according to any one of claims 1 to 7, the second optocoupler (1₁₃) being connected at the output to a second transistor (13) of said inverter arm.

15. Device integrating a system according to any one of claims 8 to 10, the device being taken from among:
- cut-off supplies,
- AC/AC, AC/DC, DC/DC converters,
- insulated digital data transmission devices,
- charge controlling devices.
